# EUROPÄISCHE PATENTSCHRIFT

(11) **EP 1 719 174 B1**
(45) Veröffentlichungstag und Bekanntmachung des Hinweises auf die Patenterteilung: **26.03.2008**
(21) Anmeldenummer: 05729533.9
(22) Anmeldetag: 16.02.2005
(51) Int. Cl.: H01L 23/485

(54) **SCHUTZDIODE ZUM SCHUTZ VON HALBLEITERSCHALTKREISEN GEGEN ELEKTROSTATISCHE ENTLADUNGEN**
PROTECTIVE DIODE FOR PROTECTING SEMICONDUCTOR SWITCHING CIRCUITS FROM ELECTROSTATIC DISCHARGES
DIODE DE PROTECTION POUR PROTEGER DES CIRCUITS DE COMMUTATION A SEMI-CONDUCTEUR DES DECHARGES ELECTROSTATIQUES

(30) Priorität: 20.02.2004 DE 102004008803
(43) Veröffentlichungstag der Anmeldung: 08.11.2006
(73) Patentinhaber: Zentrum Mikroelektronik Dresden AG, 01109 Dresden (DE)
(72) Erfinder: THIEM, Steffen, 01468 Moritzburg (DE); BUSCHBECK, Steffen, 01069 Dresden (DE)
(74) Vertreter: Adler, Peter
(86) Internationale Anmeldenummer: PCT/DE2005/000268
(87) Internationale Veröffentlichungsnummer: WO 2005/081308

(56) Entgegenhaltungen:
- DE-A1- 19 746 620
- US-A- 5 594 266
- US-A1- 2002 088 978
- US-B1- 6 518 604

## Beschreibung

Die Erfindung betrifft eine Anordnung zum Schutz von Halbleiterschaltkreisen gegen elektrostatische Entladungen, mit einer Planardiode, bei der die Elektroden jeweils durch eine Vielzahl von Kontakten kontaktiert sind und die Kontakte über Metallschichten mit der Betriebspannung, einem Ein-/Ausgangspad oder der Masse verbunden sind.

Sowohl im Fertigungsprozess als auch bei einem nachfolgenden Einbau in eine übergeordnete Schaltungsanordnung, sowie dem Betrieb der integrierten Schaltung, ist diese unvermeidbaren Umwelteinflüssen ausgesetzt, zu denen beispielsweise elektrostatische Entladungen (ESD = electrostatic discharge) gehören.

Elektrostatische Ladungen entstehen durch Reibung zwischen verschiedenen Materialien und können Potentiale von mehreren kV auf einem Ladungsträger aufbauen. Bei einem Kontakt des Ladungsträgers, beispielsweise mit einem Pin des integrierten Bauelementes, fließt die gespeicherte Ladung im Nanosekundenbereich ab und erzeugt dabei kurzzeitig Ströme bis in den Amperebereich. Dieser Strom muss durch die ESD-Schutzschaltung und die entsprechenden Leiterbahnen abgeleitet werden. Die Auslegung dieser Strombahn begrenzt den ESD-Schutz in der Weise, dass durch das Überschreiten einer zulässigen Stromdichte zum Entladungszeitpunkt eine Zerstörung von Teilen der integrierten Schaltung infolge thermischer Überlastung entsteht. Da sich die Strömdichten der ESD-Entladung mit kleineren Strukturabmessungen vergrößern, gewinnt die ESD-Problematik mit zunehmender Integrationsdichte der integrierten Schaltungen an Bedeutung.

Eine aus dem Stand der Technik bekannte Maßnahme zum Schutz gegen elektrostatische Entladungen ist das Zuschalten von Schutzdioden zwischen das Ein-/Ausgangspad und dem Potential VDD sowie der Masse VSS. Die Zuschaltung erfolgt derart, dass die erste Schutzdiode mit der Kathode am Potential VDD und der Anode am Ein-/Ausgangspad und die zweite Schutzdiode mit der Kathode am Ein-/Ausgangspad und der Anode am Potential VSS angeschlossen ist.

Zur Einhaltung der Qualitätsanforderungen an moderne IC's existieren verschiedene Teststandards. Das zurzeit übliche Human-Body-Model-Testverfahren (HBM) wird mehr und mehr vom Charge-Device-Model-Testverfahren (CDM) abgelöst. Das CDM-Testverfahren stellt erhöhte Anforderungen an die Stromfestigkeit der ESD-Schutzelemente. Die Strombelastung ist etwa um den Faktor 10 größer als beim HBM-Test. Da die Zeitspanne des Stromimpulses beim CDM-Test kleiner als 1ns ist, findet praktisch eine adiabatische Erwärmung durch den Stromfluss statt. Somit wird für die Stromableitung bei einem CDM-Testverfahren mit 1kV Hochspannungsentladung wesentlich mehr Chipfläche benötigt als bei einem HBM-Testverfahren mit 4kV. Infolge dieses Mehrbedarfs an Chipfläche verliert man einen Teil der durch eine Strukturverkleinerung gewonnenen Chipfläche. Bei einem CDM-Testverfahren nimmt die Entladestromstärke durch eine Schutzdiode stark zu, was eine Vergrößerung der Diodenfläche zur Folge hat.

Mit der Zunahme der Stromstärke und der Strukturverkleinerung, welche eine höhere Integrationsdichte zur Folge hat, wird das Latch-up-Verhalten der Anordnung immer kritischer. Bedingt durch die große, beispielsweise von einem Anodenring umgebene, Kathodenfläche wird ein Substratstrom erzeugt, der tief in das Substrat eindringt und somit nicht vollständig durch die Anode aufgenommen werden kann. Dieser Strom kann dann eine Fehlfunktion in benachbarten integrierten Strukturen auslösen.

Aus der US 5,594,266 ist eine Anordnung einer Schutzdiode zum Schutz von Halbleiterschaltkreisen gegen elektrostatische Entladungen bekannt, wobei die Anordnung aus einer Planardiode mit zwei Elektroden besteht bei der die Elektroden jeweils durch Kontakte kontaktiert sind und die Kontakte über Metallebenen mit der Betriebsspannung, einem Pad oder der Masse verbunden sind, wobei die Planardiode aus einer ersten inselförmigen Elektrode besteht, die von einer zweiten Elektrode umschlossen wird, und wobei die Kontakte der ersten Elektrode mit einer ersten Metallebene und die Kontakte der zweiten Elektrode mit einer zweiten Metallebene kontaktiert sind.

Der Nachteil dieser Anordnung besteht darin, dass infolge der hohen Anforderungen an die Schutzdiode (Strombelastung) eine größere Chipfläche für die Diode benötigt wird. Mit der Zunahme der Stromstärke und der Strukturverkleinerung, welche eine höhere Integrationsdichte zur Folge hat, wird aber das Latch-up-Verhalten der Anordnung immer kritischer. Bedingt durch die große, beispielsweise von einem Anodenring umgebene, Kathodenfläche wird ein Substratstrom erzeugt, der tief in das Substrat eindringt und somit nicht vollständig durch die Anode aufgenommen werden kann. Dieser Strom kann dann eine Fehlfunktion in benachbarten integrierten Strukturen auslösen.

Aus der US 6,518,604 ist eine Schutzdiode mit langen Anoden- und Kathodenstreifen bekannt. Diese Anordnung gewährleistet, dass der im Substrat entstehende Strom an der Oberfläche abgesaugt wird und nicht tief in das Substrat eindringen kann. Bei dieser Art der Diode ist der Stromfluss durch den Diodenrand größer als der Strom durch die Grundfläche.

Der Nachteil dieser Anordnung besteht in einem erhöhten Flächenbedarf, da die Aufteilung in Diodenfinger infolge des notwendigen Abstands zwischen Anoden- und Kathodenkontaktgebieten zusätzliche Chipfläche erfordert. Außerdem werden die Rändstücke der Diodenfinger nicht für die Stromableitung genutzt. Für lange Finger muss die Dimensionierung der Metallleitungen für die einzelnen Anoden- und ICäthodenleitungen der Stromdichte angepasst werden. Diese Anpassung erfordert, unter der Einhaltung von Designregeln, einen weiteren Platzbedarf.

Aus der DE 197 46 620 ist eine Halbleiterdiode mit zwei Elektroden, die Kathode und Anode bilden bekannt, wobei mindestens eine der Elektroden gekrümmt ist, und die Oberfläche der anderen Elektrode höchstens 20% des Produkts aus Breite der anderen Elektrode und der inneren Randlänge der gekrümmten Elektrode beträgt.

Aus der US 2002/0088978 ist ein verfahren zur Herstellung eines Substrates bekannt, welches in Reihen und Spalten angeordnete aktive Elemente enthält. Wobei jedes einzelne Element mit einem TFT-Transistor verbunden ist, welcher eine mit der zugehörigen Reihenleitung verbundene Gatterelektrode und mit der entsprechenden Reihenleitung verbundene Source- und Drain-Anschlüsse aufweist. Eine ESD-Schutzschaltung ist mit mindesten einer Reihenleitung zum Schutz des TFT-Transistors gegen elektrostatische Aufladung verbunden.

Der Erfindung liegt somit die Aufgabe zugrunde, eine Anordnung einer Schutzdiode zum Schutz von Halbleiterschaltkreisen gegen elektrostatische Entladungen zu schaffen, mit der ein verbesserter ESD-Schutz mit einer optimalen Chipflächennutzung und einem verbesserten Latch-up-Verhalten erreicht wird.

Gemäß der Erfindung wird die Aufgabe bei einer Anordnung einer Schutzdiode zum Schutz von Halbleiterschaltkreisen gegen elektrostatische Entladungen der eingangs genannten Art dadurch gelöst, dass in einer gemeinsamen ersten Elektrode mehrere Planardioden mit jeweils einer zweiten inselförmigen Elektrode, die von der ersten Elektrode umschlossen werden, angeordnet sind, dass die Kontakte der Elektrode mit einer ersten Metallebene und die Kontakte der Elektrode mit einer darüber liegenden zweiten Metallebene kontaktiert sind.

Die Realisierung von Dioden auf Wafern wird vorzugsweise in der Form einer Planardiode mit einem großen Flächenquerschnitt des pn-Übergangs ausgeführt. Gemäß der erfinderischen Lösung ist eine erste Elektrode in der Fläche der zweiten Elektrode eingebettet, wobei die inselförmige erste Elektrode beispielsweise eine kreisförmige oder rechteckige Form aufweist. Beide Elektroden sind jeweils mit verschiedenen darüber liegenden Metallebenen durch eine Vielzahl von Kontakten elektrisch leitend verbunden. Durch die Verwendung einer Vielzahl von parallel geschalteten, elektrisch leitenden Kontakten werden Widerstandsschwankungen der Einzelkontakte ausgeglichen und die Stromdichte in der Zuleitung reduziert.

In einer Ausgestaltung der Erfindung ist vorgesehen, dass mehrere Planardioden nebeneinander angeordnet sind.

In einer weiteren Ausgestaltung der Erfindung ist vorgesehen, dass mehrere Planardioden in einem Array angeordnet sind.

Diese Anordnung beispielsweise mehrerer Kathodeninseln in einer gemeinsamen Anodenfläche kann in einer Reihe, in einer Spalte, einer Kombination aus der Reihen- und der Spaltenanordnung sowie in der Form eines Arrays erfolgen.

In einer besonderen Ausführung der Erfindung ist vorgesehen, dass die Planardioden zu einer Funktionseinheit zusammengeschaltet sind.

Vorzugsweise sind die Planardioden in einer Parallelschaltung zu einer Schutzdiode, welche für eine zu einem zuverlässigen ESD-Schutz erforderlichen Strombelastung dimensioniert ist, zusammengeführt. Die so erzeuget Schutzdiode kann auch aus mehreren zusammengeschalteten Planardiodenreihen und/oder Planardiodenspalten oder mehreren Arrays bestehen.

Technologiebedingt wird zur Kontaktierung der Elektroden eine Vielzahl von Kontakten verwendet. Unter Beachtung des Leitungswiderstandes und der Strombelastbarkeit-des Kontakts kann bei entsprechender Dimensionierung nur ein Kontakt, zur Verbindung einer Elektrode mit einer Metallebene, genutzt werden.

In einer Ausführung der Erfindung ist vorgesehen, dass die inselförmige Elektrode eine kreisförmige oder eine n-eckige Form aufweist.

Die Form der inselförmigen Elektrode kann beispielsweise an eine verwendete Herstellungstechnologie angepasst werden. Die Elektrode kann sowohl eine kreisförmige als auch eine eckige Form, mit einer beliebigen Eckenanzahl, aufweisen.

Die Erfindung soll nachfolgend anhand eines Ausführungsbeispiels näher erläutert werden. In den zugehörigen Zeichnungen zeigt
- Fig. 1: eine ESD-Schutzschaltung mit zwei Schutzdioden aus dem Stand der Technik,
- Fig. 2: eine Darstellung der untersten Layoutebene der erfindungsgemäßen Schutzdiode,
- Fig. 3: eine Darstellung der Verbindung der Anoden- und Kathodenflächen mit der darüber liegenden ersten Metallebene,
- Fig. 4: eine Darstellung der ersten Metallebene mit Via-Kontakten und
- Fig. 5: eine Darstellung der zweiten Metallebene mit Via-Kontakten.

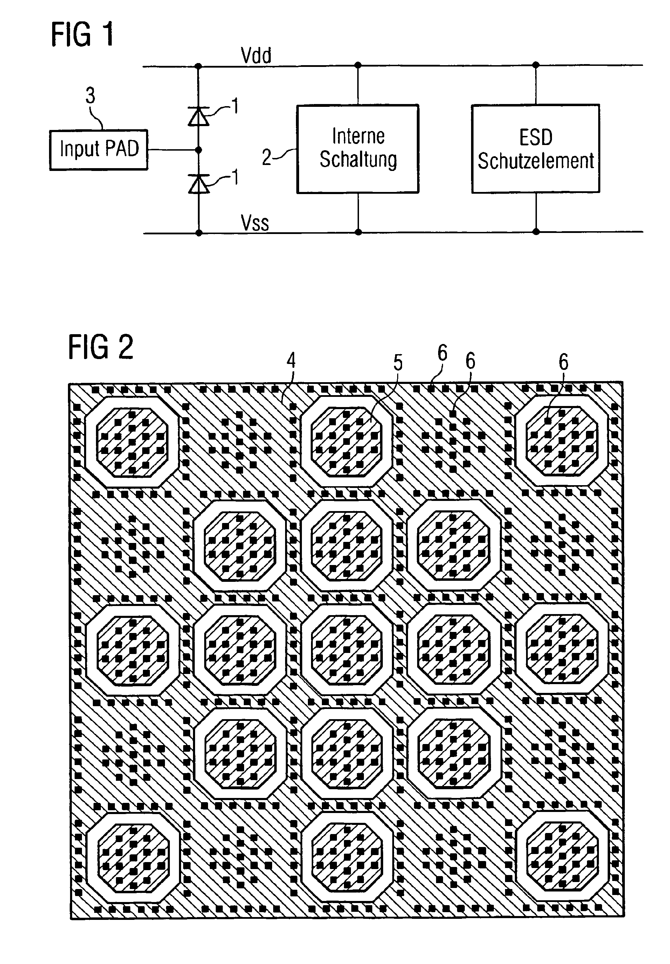

In der Figur 1 ist eine ESD-Schutzschaltung mit zwei Schutzdioden 1 aus dem Stand der Technik dargestellt. Mit dieser Anordnung wird die interne Schaltung 2 vor elektrostatischen Entladungen an einem der Input-PAD's 3 geschützt. Die erfinderische Lösung kann in beiden Schutzdioden 1 Anwendung finden.

Einen für eine Flächenoptimierung verbesserten Diodenentwurf, einer als Planardiode ausgeführten Diode, erzielt man, wenn die Diode nicht in Anoden- und Kathodenstreifen unterteilt, sondern eine Anodenfläche 4 mit einer darin eingebetteten Kathodeninseln 5 verwendet wird. Eine Anordnung der Planariode mit einer Anodeninsel in einer Kathodenfläche ist ebenfalls möglich. Mit dieser Lösung kann die Fläche der Kathodeninsel 5, die Anodenfläche 4, der Rand der Kathodeninsel 5, die Anzahl der Kontakte 6 sowohl in der Kathodeninsel 5 als auch in der Anodenfläche 4 und die Metallbahnbreiten so optimal aufeinander abgestimmt werden, dass bei einer Zusammenschaltung mehrerer Planardioden zu einer Schutzdiode 1 jedes Planardiodenelement der gleichen Strombelastung standhält. Durch die Wahlmöglichkeiten in Bezug auf Form und Größe der Insel 5 kann ein flächenoptimierter Entwurf gefunden werden. Durch die Unterteilung der Schutzdiode 1 in kleine Teilflächendioden wird ein signifikanter Substratstrom zu benachbarten Chipelementen verhindert. Je nach vorhandenem Platz im Layout kann die Struktur, der aus mehreren Planardioden bestehenden Schutzdiode 1, quadratisch, rechteckig oder in mehrere Teilstrukturen aufgeteilt ausgeführt werden.

Gemäß der erfinderischen Lösung ist die Kathodeninsel 5 in einer achteckigen Form mit Winkeln von jeweils 45 Grad ausgeführt. Eine andere geometrische Form, beispielsweise eine kreisförmige oder quadratische Form, ist ebenfalls möglich. Zur Gewährleistung eines gleichmäßig verteilten Stromflusses durch alle Inseln 5 ist deren Größe, geometrische Form, die Einbettung und die Kontaktierung 6 der Inseln 5 jeweils gleich auszuführen. Pro Insel 5 werden beispielsweise 10 Kontakte 6 verwendet, um Widerstandsschwankungen der Kontakte 6 auszugleichen. Die Stromzuleitung zu den Inseln 5 erfolgt über Kontakte 6 zu einer darüber liegenden ebenfalls inselförmigen Metallplatte in der ersten Metallebene 7 und nachfolgend weiter über Via's zu einer darüber liegenden zweiten Metallebene 8, in der die Teilströme der Inseln 5 zusammengefasst werden. Somit ist gewährleistet, dass der Gesamtdurchlassstrom gleichmäßig auf alle parallel geschalteten Inseln 5 aufgeteilt wird. Da sich die zweite Metallebene 8 großflächig über die gesamte Diodenfläche erstreckt, stellt die Stromdichte in dieser Metallebene 8 keine Begrenzung für den möglichen Strom durch die Dioden dar. Die Elektrödenfläche 4, in der die Inseln 5 eingebettet werden, füllt die Gebiete zwischen den Inseln 5, unter Einhaltung minimaler Designregeln aus. Dabei muss beispielsweise die Anodenfläche 4 mindestens gleich groß der Summe der Kathodeninselfläche sein, damit keine Substratströme zu anderen Chipelementen auftreten können. Weiterhin muss die Verteilung der Kathodeninseln 5 zum Rand der Anodenfläche 4 abnehmen, um die Stromdichte in der ersten Metallebene 7, welche die Anoderizuleitung darstellt, annähernd konstant zu halten. Die Anbindung der Anodenfläche 4 erfolgt ebenfalls durch Kontakte 6 zu der erste Metallebene 7, wobei eine Überlappung der Metallebene 7 an den Außenseiten notwendig ist, und dadurch ein vierseitiger Anschluss der Anodenfläche 4 über die erste Metallebene 7 an eine zugehörige Leitung möglich wird.

In den Figuren 2 bis 5 ist eine Umsetzung der erfindurigsgemäßen Anordnung in verschiedenen, übereinander liegenden Layoutebenen dargestellt. Die unterste Ebene ist in der Figur 2 dargestellt. In dieser Ebene sind die Kathodeninseln 5 und die Anodenfläche 4 im Siliziumsubstrat dargestellt. Sowohl die Kathodeninseln 5 als auch die Anodenfläche 4 sind mit Kontäktstöpseln 6 für den Anschluss an die erste Metalleben 7 bestückt.

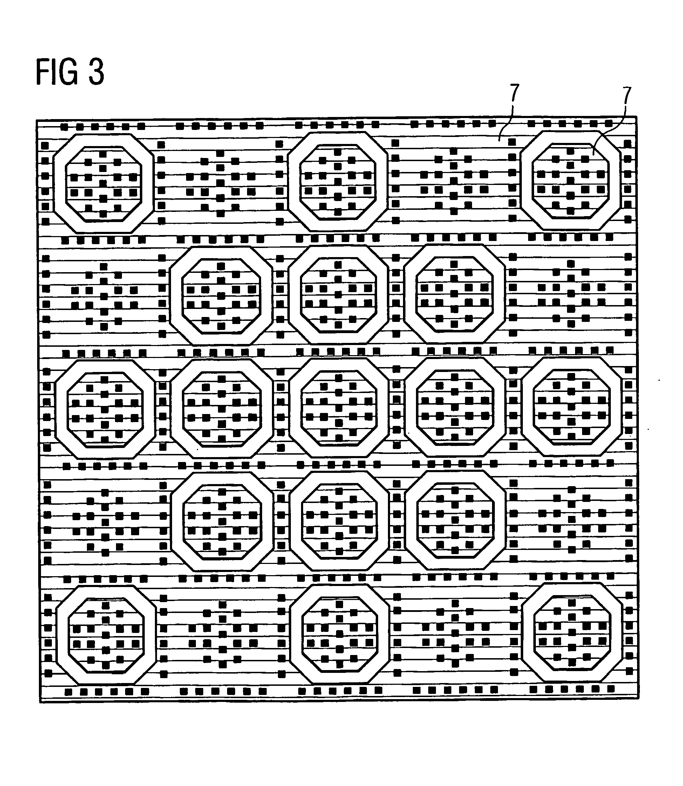

In der Figur 3 ist die Verbindung der Kathodeninseln 5 und der Anodenfläche 4 mit der darüber liegenden ersten Metallebene 7 dargestellt. Alle Anodenanschlüsse werden auf eine gemeinsame Metallplatte in der ersten Metallebene 7 geführt, die dann an allen Seitenrändern beispielsweise mit dem GND-Bus verbunden wird. Die Metallflächen über den Inseln 5 sind in der ersten Metallebene 7 sowohl zueinander als auch gegenüber der restlichen Metallfläche der gleichen Ebene isoliert und werden durch Kontakte 6 von der ersten Metallebene 7 nach oben zu der darüber liegenden zweiten Metallebene 8 verbunden. Derartige Kontakte 6 werden auch als Via's bezeichnet.

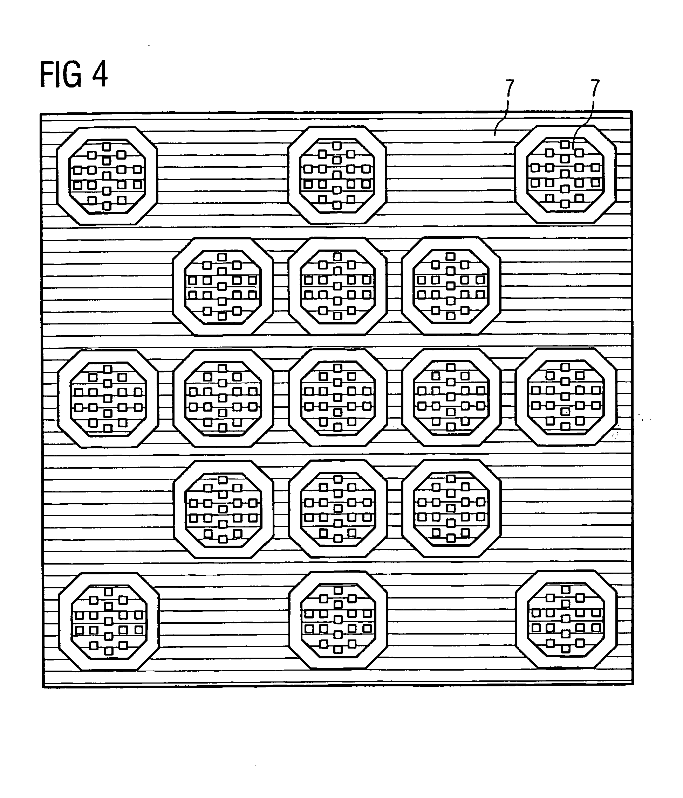

In der Figur 4 ist die erste Metallebene 7 mit den Via-Kontakten dargestellt. Diese Via-Kontakte werden dann mit der zweiten Metallebene 8 verbunden.

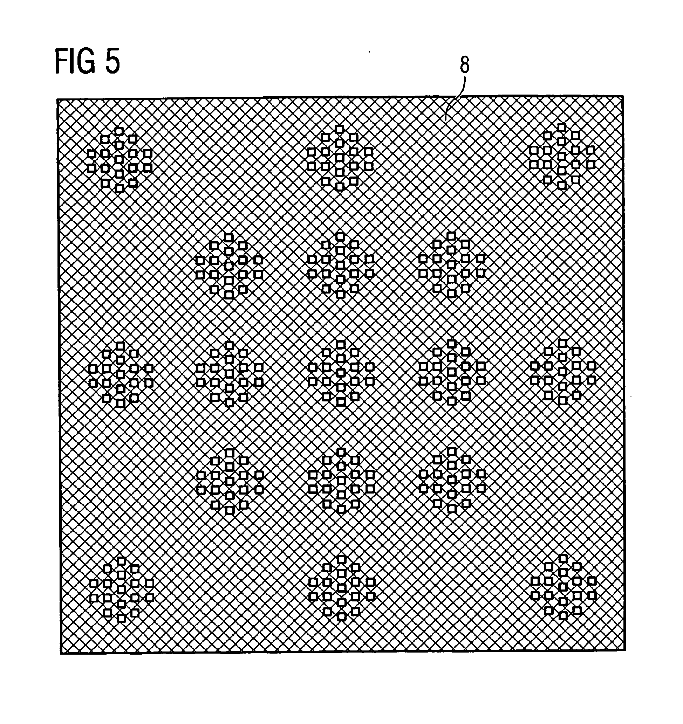

In der Figur 5 ist die zweite Metallebene 8 mit den verbundenen Via-Kontakten dargestellt. Diese Metallebene 8 wird hinreichend groß dimensioniert, so dass sie keine Schädigung nach einer Strombelastung durch eine elektrostatische Entladung aufweist. Die Anbindung, beispielsweise an ein Input-PAD, erfolgt über diese Metallebene 8.

### Bezugszeichenliste

- 1: Schutzdiode
- 2: Interne Schaltung
- 3: Input PAD
- 4: Anodenfläche
- 5: Kathodeninsel
- 6: Kontakt
- 7: erste Metallebene
- 8: zweite Metallebene

## Patentansprüche

1. Anordnung zum Schutz von Halbleiterschaltkreisen gegen elektrostatische Entladungen, mit einer Planardiode mit zwei Elektroden, bei der die Elektroden jeweils durch eine Vielzahl von Kontakten kontaktiert sind und die Kontakte über Metallebenen mit der Betriebspannung, einem PAD oder der Masse verbunden sind, **dadurch gekennzeichnet, dass** in einer gemeinsamen ersten Elektrode (4) mehrere Planardioden mit jeweils einer zweiten inselförmigen Elektrode (5), die von der ersten Elektrode (4) umschlossen werden, angeordnet sind, dass die Kontakte (6) der Elektrode (5) mit einer ersten Metallebene (7) und die Kontakte (6) der Elektrode (4) mit einer darüber liegenden zweiten Metallebene (8) kontaktiert sind.

2. Anordnung nach Anspruch 1, **dadurch gekennzeichnet, dass** mehrere Planardioden nebeneinander angeordnet sind.

3. Anordnung nach Anspruch 1, **dadurch gekennzeichnet, dass** mehrere Planardioden in einem Array angeordnet sind.

4. Anordnung nach Anspruch 2 oder 3, **dadurch gekennzeichnet, dass** die Planardioden zu einer Funktionseinheit zusammengeschaltet sind.

5. Anordnung nach Anspruch 1, **dadurch gekennzeichnet, dass** die inselförmige Elektrode (5) eine kreisförmige oder eine n-eckige Form aufweist.

## Claims

1. Arrangement for protecting semiconductor switching circuits from electrostatic discharges, having a planar diode with two electrodes, in which the electrodes in each case are contacted by a plurality of contacts and the contacts are connected to the operating voltage, a PAD or earth by metallic planes, **characterized in that** within a common first electrode (4) a plurality of planar diodes are arranged in each case with a second insular electrode (5), which are surrounded by the first electrode (4), and **in that** the contacts (6) of the electrode (5) are contacted by a first metallic plane (7) and the contacts (6) of the electrode (4) by a second, superimposed metallic plane (8).

2. Arrangement according to Claim 1, **characterized in that** a plurality of planar diodes are arranged adjacent to one another.

3. Arrangement according to Claim 1, **characterized in that** a plurality of planar diodes are arranged in an array.

4. Arrangement according to Claim 2 or 3, **characterized in that** the planar diodes are hooked up to a functional unit.

5. Arrangement according to Claim 1, **characterized in that** the insular electrode (5) has a circular or an n-angular form.

## Revendications

1. Dispositif de protection de circuits de commutation à semiconducteur contre des décharges électrostatiques, comprenant une diode planaire avec deux électrodes, les électrodes étant respectivement en contact par une pluralité de contacts reliés par des plans métalliques à la tension de service, à un dispositif PAD (dispositif de pertes) ou à la masse,
**caractérisé en ce que**
dans une première électrode commune (4) sont disposées plusieurs diodes planaires avec respectivement une deuxième électrode insulaire (5), entourée par la première électrode (4), les contacts (6) de l'électrode (5) sont en contact avec un premier plan métallique (7) et les contacts (6) de l'électrode (4) sont en contact avec un deuxième plan métallique (8) situé au-dessus.

2. Dispositif selon la revendication 1,
**caractérisé en ce que**
plusieurs diodes planaires sont disposées les unes à côté des autres.

3. Dispositif selon la revendication 1,
**caractérisé en ce que**
plusieurs diodes planaires sont disposées dans un réseau.

4. Dispositif selon la revendication 2 ou 3,
**caractérisé en ce que**
les diodes planaires sont connectées pour former une unité fonctionnelle.

5. Dispositif selon la revendication 1,
**caractérisé en ce que**
l'électrode insulaire (5) présente une forme circulaire ou à n côtés.
